(19) Europäisches Patentamt / European Patent Office / Office européen des brevets

(11) **EP 2 439 496 A1**

(12) **EUROPEAN PATENT APPLICATION**

(43) Date of publication:
**11.04.2012 Bulletin 2012/15**

(51) Int Cl.:
*G01D 4/00* (2006.01)  *G01R 31/02* (2006.01)
*H02J 4/00* (2006.01)  *G06Q 50/00* (2012.01)

(21) Application number: **10290534.6**

(22) Date of filing: **06.10.2010**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **Alcatel Lucent**
**75007 Paris (FR)**

(72) Inventors:
• **Stocker, Klaus Erwin**
**70567 Stuttgart (DE)**
• **Kopp, Dieter**
**75428 Illingen (DE)**

(74) Representative: **Michalski Hüttermann & Partner**
**Neuer Zollhof 2**
**40221 Düsseldorf (DE)**

(54) **Detection of loss in electrical distribution networks**

(57) The invention proposes a method for detecting loss in an electrical distribution network. The method comprises a step of receiving average measured voltage values and average measured current values associated with one or more points of supply within the electrical distribution network, and a step of receiving average measured voltage values and average measured current values associated with a plurality of points of consumption within the electrical distribution network. Furthermore, the method comprises the step of calculating conductivity paramters based on said received average measured voltage values and average measured current values and the step of receiving further average measured voltage values and average measured current values associated with said points of supply within the electrical distribution network. Still further the method comprises the steps of receiving furher measured average voltage values and average current values associated with said points of consumption within the electrical distribution network and analyzing said further received average measured voltages and average measured currents using said calculated conductivity paramters to detect any deviations of measured currents values from calculated currents values with respect to a given point of consumption or point of supply.

Fig. 3

**Description**

The present invention relates to the field of power measurement.

Detection of non-technical loss of electrical energy is a problem for any electric utility. If electrical energy is lost due to fraudulent actions, e.g. by use of a connection to the network bypassing the respective electricity meter, it is very difficult for the utility to analyze the location of the theft as well as the time/duration as well as the value of the theft.

Although the awareness grows, there exist markets where more than 10 % of the provided energy is consumed by theft or without authorization, thereby causing a significant threat to revenues.

Even where accurate values, e.g. measured by smart meters, are available, it has not been possible to accurately detect the location, time and amount of an electrical energy theft.

Still further, it is difficult to provide legal proof of an electrical energy theft after it is detected.

There exist solutions which are based on data mining and neural networks. However none of the known methods is accurate enough to provide an accurate indication of the location, time and amount of an electrical energy theft. The majority of these methods is based on comparisons with historical data and load profiles or others. These methods are in general only able to provide an indication that there is a fraudulent action while they do not provide an indication of the theft time and amount.

Furthermore, there exist solutions within a smart meter intended to detect direct manipulation of the meter itself. However, one such smart meter is not able to detect a bypass thereof.

Additionally one may compare measurements by a group of meters which are located in the point of delivery, i.e., within a certain feed, with the combined readings from the meters Of the supplied consumers. However, since the load within a distribution network and the portions thereof varies neither the exact location nor the amount of an electrical energy theft can be determined.

Even if one would combine two or more of the different solutions, the resulting solution fails to provide an accurate indication of the location, time and amount of the theft.

It is therefore an object of an embodiment of the invention to provide a method which allows for providing an accurate detection of loss in electrical distribution networks.

The problem is solved by a method for detecting loss in an electrical distribution network. In a first step average measured voltage values and average measured current values associated with one or more points of supply within the electrical distribution network are received. In another step average measured voltage values and average measured current values associated with a plurality of points of consumption within the electrical distribution network are received. Based on said received average measured voltage values and average measured current values conductivity parameters are calculated. Thereafter, in a further step further average measured voltage values and average measured current values from said points of supply within the electrical distribution network are received. In another step further average measured voltage values and average measured current values from said points of consumption within the electrical distribution network are received. Thereafter said further received average measured voltages and average measured currents are analyzed using said calculated conductivity parameters to detect any deviation of measured current values from calculated current values with respect to a given point of consumption or point of supply.

In an embodiment of the invention the received average measured voltage values and average measured current values are averaged over a predetermined period of time.

In a further embodiment of the invention from the analysis of points is determining a location of loss is determined.

In yet another embodiment of the invention from the analysis of points an amount of loss is determined.

According to still another embodiment of the invention the calculation of conductivity paramters is based on an optimization method.

In a further embodiment the optimization method is selected from the group comprising Quasi Newton, Conjugated Gradient, Simplex Method, Fuzzy Logic, Evolution Methods.

According to yet another embodiment the result of the analysis can be visualized.

The problem is also solved by a system adapted for detecting loss in an electrical distribution network- The System comprises a first logical receiver adapted for receiving average measured voltage values and average measured current values associated with one or more points of supply within the electrical distribution network, and a second logical receiver for receiving average measured voltage values and average measured current values associated with a plurality of points of consumption within the electrical distribution network. Additionally said system comprises a Calculation Unit adapted for calculating conductivity parameters based on said received average measured voltage values and average associated with current values. Said first logical Receiver is further adapted for receiving further average measured voltage values and average measured current values associated with said points of supply within the electrical distribution network and said second logical Receiver is further adapted for receiving further measured average voltage values and average current values associated with said points of consumption within the electrical distribution network. Said Calculation Unit is further adapted for analyzing said further received average measured voltages and average measured currents using said calculated conductivity parameters to detect any deviations of measured current values from calculated current values with respect to a given point of consumption or point of supply.

According to another embodiment of the invention the Calculation Unit is further adapted to average said received average measured voltage values and average measured current values over a predetermined period of time.

Still in a further embodiment according to the invention said Calculation Unit is further adapted for determining from the analysis of points a location of loss.

In yet another embodiment said Calculation Unit is further adapted for determining from the analysis of points an amount of loss.

According to a further embodiment according to the invention said Calculation Unit is further adapted for calculating of conductivity parameters based on an optimization method.

In a further embodiment of the invention the optimization method is selected from the group comprising Quasi Newton, Conjugated Gradient, Simplex Method, Fuzzy Logic, and Evolution Methods.

Still in another embodiment of the invention said Calculation Unit is further adapted for visualizing the result of the analysis.

Brief Description of the Figures

Some embodiments of apparatus and/or methods in accordance with embodiments of the present invention are now described, by way of example only, and with reference to the accompanying drawings, in which:

Figure 1 shows schematically an exemplary electrical distribution network,
Figure 2 shows schematically an equivalent circuit of the exemplary electrical distribution network of Figure 1,

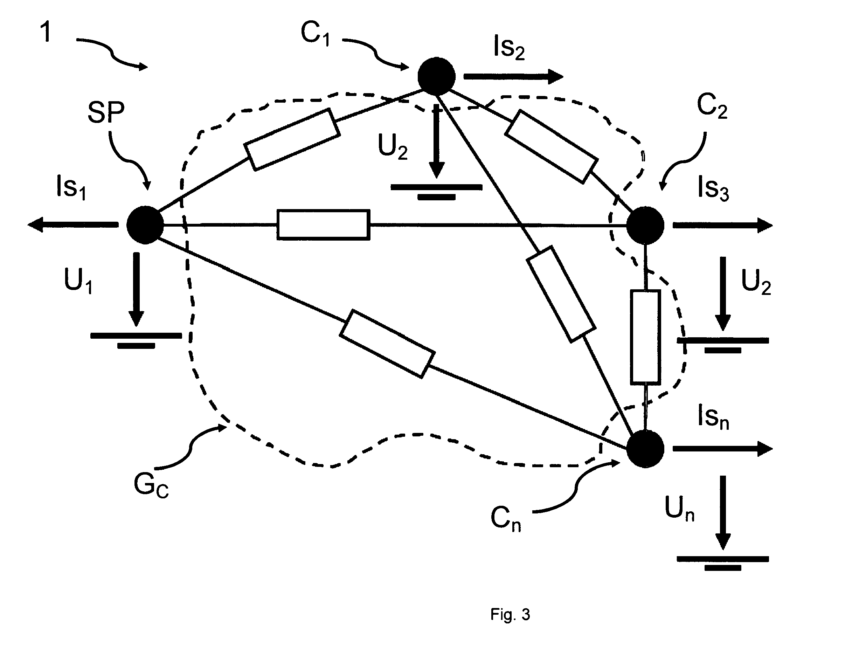

Figure 3 shows schematically an equivalent circuit of the exemplary electrical distribution network of Figure 1 being used within Detection,
Figure 4 shows a table of numerical results derived by a method according to an embodiment of the invention,
Figure 5 shows a graphical representation of numerical results derived by a method according to an embodiment of the invention,

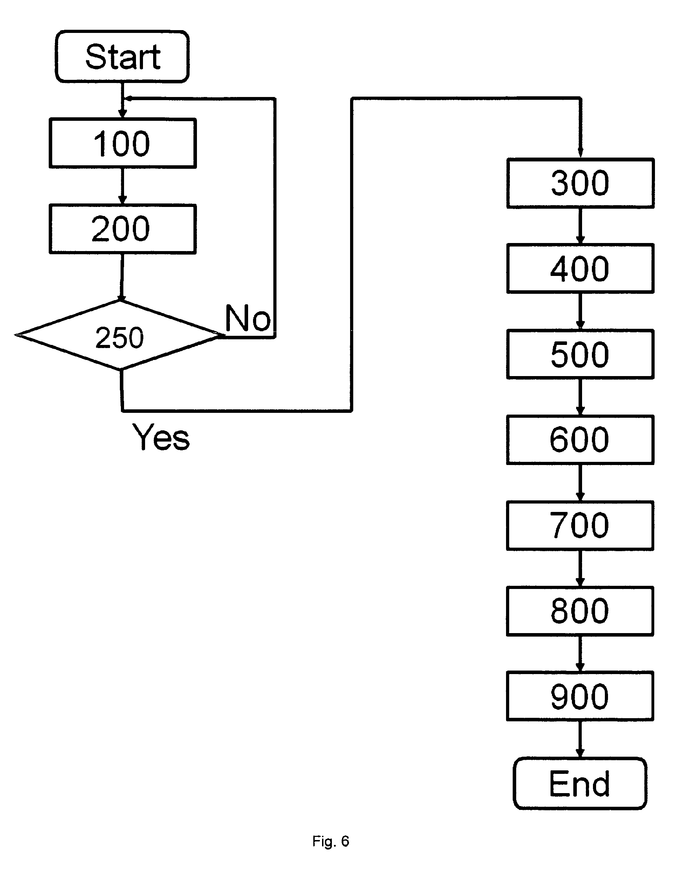

Figure 6 shows an exemplary flow diagram according to different embodiments of the invention, and

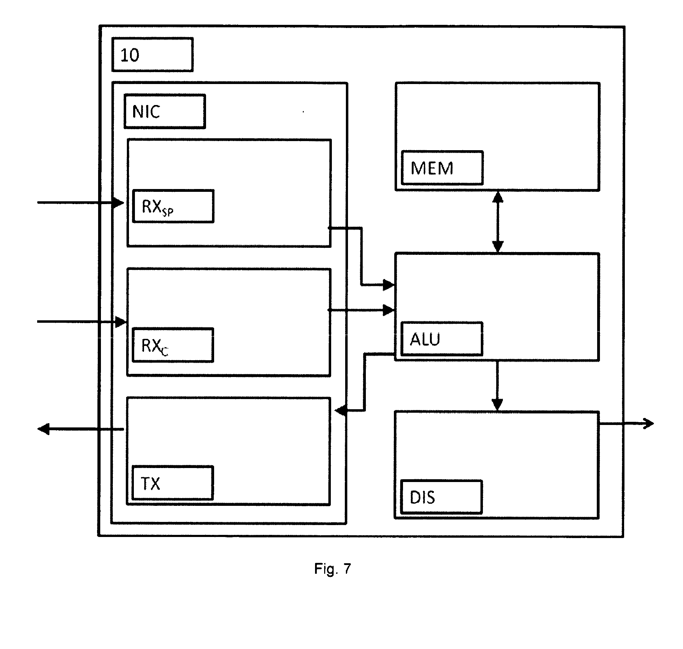

Figure 7 shows schematically exemplary system according to the invention.

The following embodiments of the invention will be described with respect to the figures.

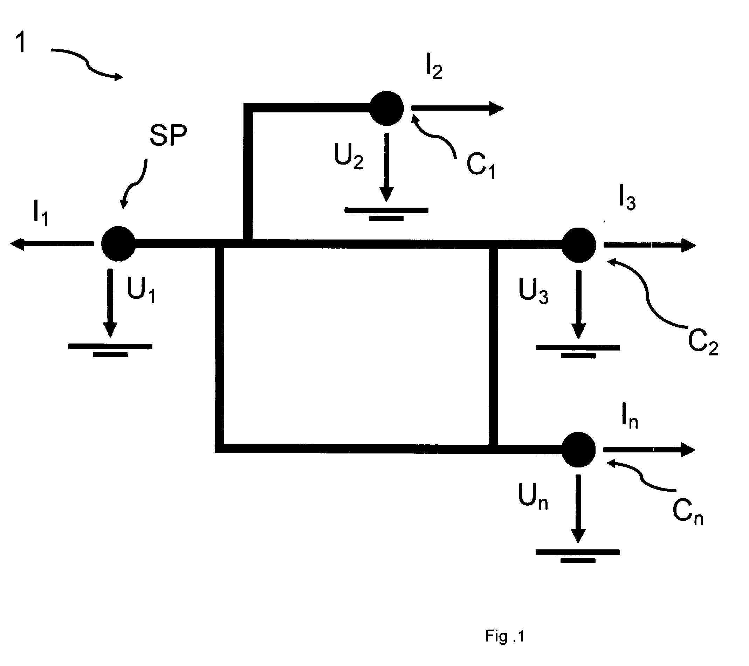

In Figure 1 an exemplary electrical distribution network 1 in one embodiment is shown.

Within said network 1, a power supplier SP is indicated on the right side of the figure. The power supplier SP delivers a current I, at a certain potential $U_1$ towards the network. Furthermore, said network 1 comprises a plurality of consumers $C_1$, $C_2$ ... and $C_n$, where n represents a predetermined integer.

Each Consumer consumes at a certain voltage (or potential difference) certain current. Said current may be understood as a measured current at a measured voltage. For example, Consumer $C_1$ consumes power which may be evaluated by the measured current $I_2$ and the measured voltage $U_2$, Consumer $C_2$ consumes power which may be evaluated by the measured current $I_3$ and the measured voltage $U_3$ and Consumer $C_n$ consumes power which may be evaluated by the measured current In and the measured voltage $U_n$.

Said network 1 may be meshed in any given arrangement as indicated in the Figure, i.e. it may even comprise loops. The distribution network can be completely unknown in its topology and conductivity for the procedure.

Every load, be it consumption or supply, in the network leads to a negative or positive voltage drop that has an influence on the voltages in the whole network.

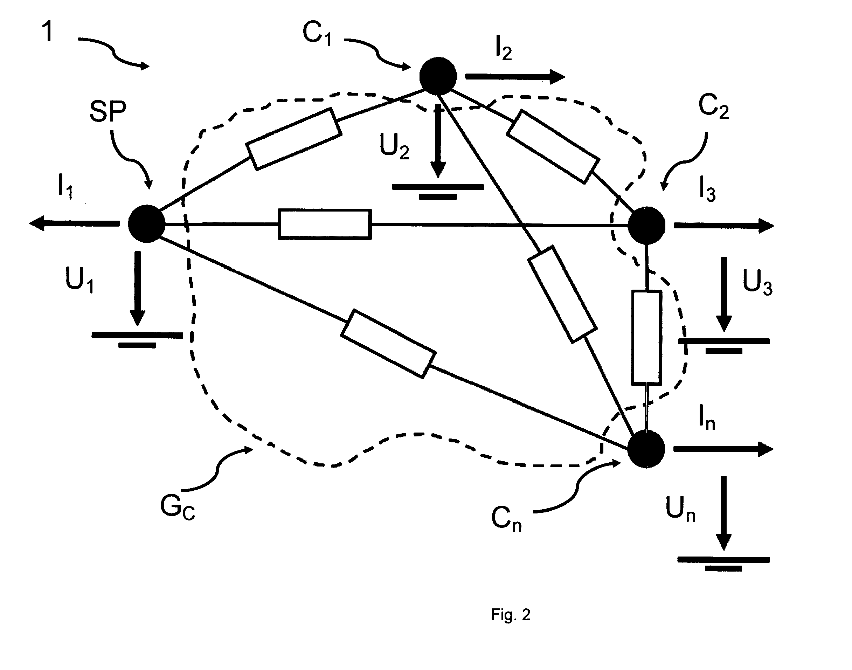

The network of Figure 1 and the associated loads may be described as a network of conductance as shown in Figure 2.

There, the plurality of consumers $C_1$, $C_2$ and $C_n$ and the Power Supplier SP are connected one another by certain conductance.

A consumer represents a point of consumption wile a power supplier represents a poit of supply.

The network of conductance is represented by a dashed cloud $G_C$.

Within said network each supplier and each consumer measures the voltage and current. It is understood that these measured voltage and current may also be averages themselves, i.e. averages over a given period.

For convenience, and without loss of generality, it will be assumed in the following that the measured potential and currents are measured at the same time. If the measured potential and currents concern averages themselves it is assumed that they are as well averages with respect to the same time period, e.g. with respect to a certain amount of minutes, e.g. 1 min, 5 min, 15 min, 30 min, 60 min, ....

Now, assuming that there is a conductance in between each element - supplier(s) and consumer(s) - in the electrical distribution network 1, one can state, that there is a voltage drop across each element. Said voltage drop may be calculated in the following manner on basis of the measured value across each element of the electrical distribution

network:

$$\delta U_{11} = U_1 - U_1$$
$$\vdots$$
$$\delta U_{1n} = U_1 - U_n$$

Based on the derived voltage drop, one may determine a simulated current through each element as follows:

$$Is_1 = g_{11} * \delta U_{11} + g_{12} * \delta U_{12} + \cdots g_{1n} * \delta U_{1n}$$
$$\vdots$$
$$Is_n = g_{n1} * \delta U_{n1} + g_{n2} * \delta U_{n2} + \cdots g_{nn} * \delta U_{nn}$$

where Is represents a simulated current through a network element.

In this instance, Is, represents a simulated current from the power supplier SP; $Is_2$ represents a simulated current to Consumer $C_1$, $Is_3$ represents a simulated current to Consumer $C_2$, and $Is_n$ represents a simulated current to Consumer $C_n$.

These simulated currents are based on the network of conductance expressed as a matrix as follows:

$$G_C = \begin{pmatrix} g_{11} & \cdots & g_{1n} \\ \vdots & \ddots & \vdots \\ g_{n1} & \cdots & g_{nn} \end{pmatrix}$$

The conductivity matrix $G_c$ is determined based on the following understanding:

$$Err(t) = (I_1 - Is_1)^2 + \cdots + (I_n - Is_n)^2$$

$$Err(t_1 \cdots t_k) = Err(t_1) + Err(t_2) + \cdots Err(t_k)$$

where $t_1 \ldots t_k$ indicates a time period.

It can be shown that the number of criteria provided by the two equations above needs to be sufficiently high such that the number of unknown matrix elements may be calculated.

The number of unknown matrix elements depends on the size of the network which impacts the coupling of matrix elements. I.e. the larger the network is the less impact is to expected from elements within the network elements which are distant to each other. This finding may be used to assume that the a certain number of matrix elements is held to be 0, i.e. there is no need to determine these matrix elements.

Assuming a smaller network and, hence, a stronger coupling, the number of unknown matrix elements p may be determined as follows:

$$p = 0.5 * n * (n+1),$$

where n is the number of criteria.

Assuming a larger network and, hence a looser coupling, the number of unknown matrix elements p may be defined as follows:

$$p < 0.5 * n * 50.$$

Here, the calculation is based on an estimated band matrix. As can be seen from the above, it is assumed that once a concerned network comprises more than 50 nodes, one may assume loose coupling. This estimation is a good assumption and reduces the overall necessary calculations. Nevertheless, if calculation time is of no concern, there is no necessity to assume loose coupling.

It can be shown that the number of criteria n given by equations Err (t) and Err $(t_1...t_k)$ are equal to or higher than the number of unknown matrix elements p.

Per time period $t_1 ... t_k$, the number of criteria is n. By considering the above inequality p $<0.5*n*50$ in case of loose coupling, one would need 25 time periods for the calculation of Gc.

The unknown matrix elements $g_{mn}$ are calculated using any appropriate optimization methods, such as Quasi Newton, Conjugated Gradient, Simplex Method, Fuzzy Logic, Evolution Methods, etc.

The optimization method may be chosen such that further parameters are taken into account such as time necessity and / or accuracy and / or efficiency.

It is understood that the intended target of the optimization is to minimize Err $(t_1...t_k)$ to be as close to zero as possible by varying the matrix elements $g_{mn}$ until the intended target given is reached.

After the matrix is determined, the detection of loss may be performed.

The analysis of time and location is based on the following equations:

$$Err_1(t_1) = (I_1 - Is_1)^2$$
$$\vdots$$
$$Err_n(t_n) = (I_n - Is_n)^2$$

While the analysis on an amount of an electrical energy theft is based on the following equations:

$$If_n(t_1) = (I_1 - Is_1)$$
$$\vdots$$
$$If_n(t_n) = (I_n - Is_n)$$

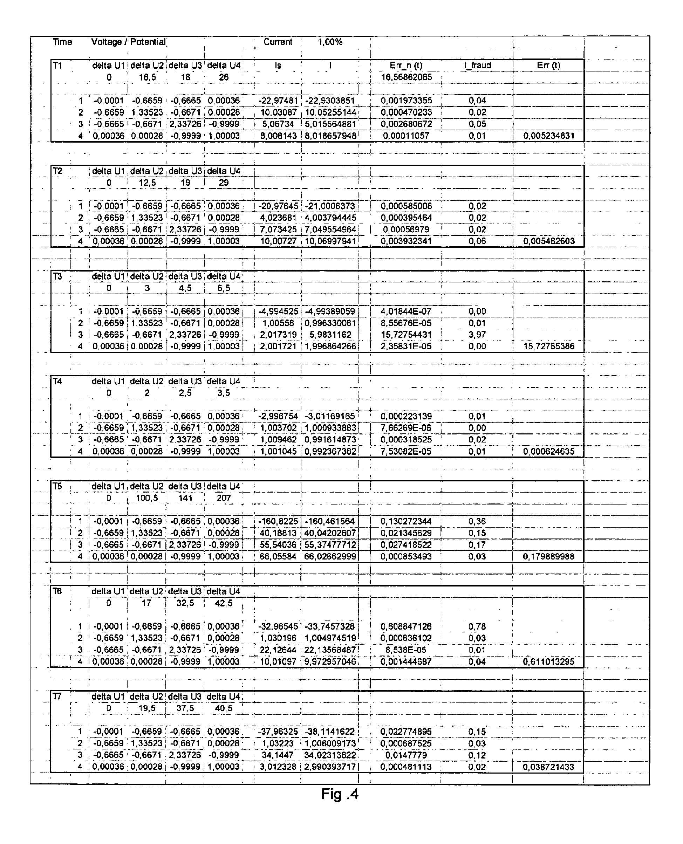

Now turning to a network comprising a Supplier SP and 3 Customers $C_1$, $C_2$ and $C_n$ as indicated in Figure 1, and assuming that the elements within the conductance matrix $G_c$ are already determined, it is assumed that the values displayed in the table shown in Figure 4 are received and further processed.

Within a first time period $T_1$ average currents and average voltage drops from the Supplier and the Customers are received. From these received values, the differential voltage drops $\delta U_{11} ...\delta U_{1n}$ are determined as well as the simulated currents $Is_1... Is_n$ with respect to each supplier and consumer.

In theory, the simulated current and the measured current shall be identical. However, due to some numerical computation as well as varying voltages and varying load, a certain amount of deviation may be assumed as normal. In the present case it is assumed that a deviation within 5 % is within normalcy. This value may be subject to further fine tuning depending on numerical accuracy, time period for averaging, network size, etc.

The same is repeated for further time periods $T_2 ... T_7$.

Now turning to Time period $T_3$. There it can be seen that Consumer $C_2$ shows a deviation of more than 5 %. While the measured values leads to a simulated current $Is_2$ of 5,9831162, the measured current displays only 2,017319.

Hence, the above approach not only allows for detecting the location of a theft, customer 2, but also for quantifying the theft as almost 4 units within the time period $T_3$.

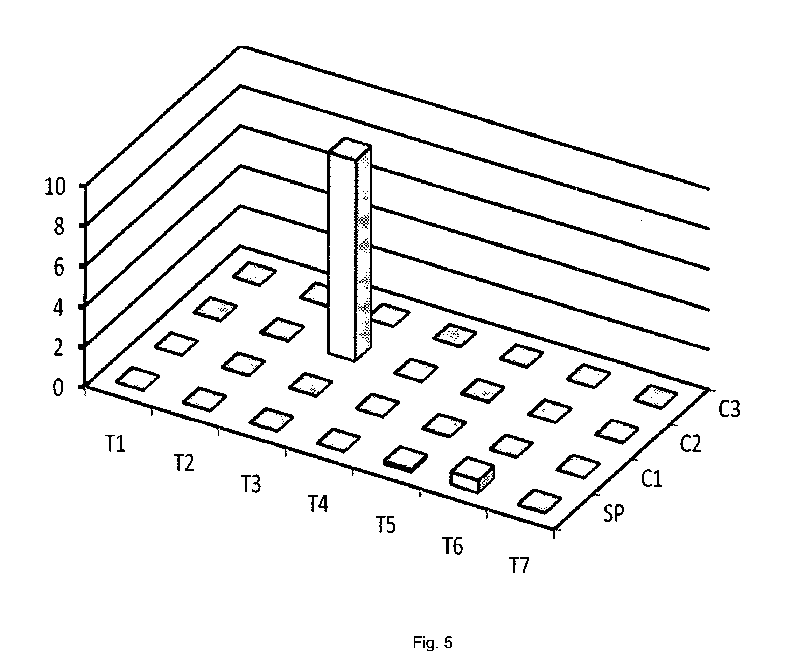

The results shown in the table may also be visualized in Figure 5. There it can easily be detected that within time period $T_3$ customer 2 has consumed more power than measured.

Thus an employee of the power distributor may easily detect the fraud and trigger a service employee to check the respective installation and / or to instigate legal actions. This may nevertheless also be automated and once a fraud is detected it would be possible to instruct services employees to check in an automated manner as well as instigating legal actions by means of a form letter.

Hence, a method according to the invention may be summarized as follows:

Average measured voltage values $U_1$ and average measured current values $I_1$ associated with one or more points of supply - such as supply locations - SP within the electrical distribution network 1 are received in a step 100.

In a further step 200 average measured voltage values $U_2, U_3, U_n$ and average measured current values $I_2, I_3, I_n$ associated with a plurality of points of consumption - such as all consumer locations - $C_1, C_2, C_n$ within the electrical distribution network 1 are received.

The steps 100 and 200 are repeated as long as necessary to provide enough criteria for calculating the matrix elements. Therefore, it is decided in a step 250 whether there are sufficient criteria available or not. If the number is not sufficient, the steps 100 and 200 are performed another time (No-branch) while if the number is sufficient, the method continues with step 300 (Yes-branch).

Based on said received average measured voltage values $U_1, U_2, U_3, U_n$ and average measured current values $I_1, I_2, I_3, I_n$ conductivity parameters of Matrix $G_c$ are calculated in a step 300.

Once the conductivity parameters are determined further average measured voltage values $U_1$ and average conductivity parameters current values $I_1$ associated with said points of supply SP within the electrical distribution network 1 are received in a step 400 and in a step 500 further average measured voltage values $U_2, U_3, U_n$ and average measured current values $I_2, I_3, I_n$ associated with said points of consumption $C_1, C_2, C_n$ within the electrical distribution network 1 are received.

Thereupon, said further received average measured voltages and average measured currents using said calculated conductivity parameters are analyzed in step 600 to detect any deviation of measured current values from calculated current values with respect to a given point of consumption or point of supply.

It is understood that the calculation may need updates from time to time to reflect a varying electrical distribution network 1. The update may be triggered by construction works in the distribution network 1 and / or may be repeated periodically, e.g. every week, every month, etc. This update may lead to a periodical (re-)start of the method.

In an embodiment of the invention the received measured average voltage values and average current values are averaged over a predetermined period of time. A predetermined time may be any suitable time period, e.g. 1 min, 5 min, 15 min, 30 min, 60 min,

In an embodiment, the method may be complemented by a step 700 following analysis, said step concerning determination from the analysis of points a location of loss. This determination may be based on a certain threshold, i.e. once a certain threshold is exceeded the deviation is determined to be a theft. Such a threshold may be any suitable value, e.g. 5 %. Said value may be subject to further fine-tuning.

In still a further embodiment, the step of analyzing 600 may be followed by a step 800 in which it is determined from the analysis of points an amount of loss. This amount is based on the deviation of calculated and measured current values of the respective network element.

In a still further embodiment the calculation of conductivity parameters of step 300 is based on an optimization method. The unknown matrix elements $g_{mn}$ are calculated through any appropriate optimization methods, such as Quasi Newton, Conjugated Gradient, Simplex Method, Fuzzy Logic, Evolution Methods, etc.

In a still further embodiment the method also comprises a step 900 in which the results of the analysis provided in steps 600 and / or 700 and / or 800 are visualized.

In another embodiment of the invention, the above method is incorporated in a system 10 adapted for detecting loss in an electrical distribution network.

Such a system 10 may be embodied in a computer or a controller comprising a first logical receiver $RX_{sp}$ adapted for receiving average measured voltage values and average measured current values associated with one or more point of supply within the electrical distribution network, and a second logical Receiver $RX_c$ for receiving average measured voltage values and average measured current values associated with a plurality of points of consumption within the electrical distribution network 1.

Said logical receivers $RX_{sp}$ and $RX_c$ may be embodied in one or more network cards connected to respective meters located at the Supplier(s) SP and Customers $C_1, C_2, C_n$. As indicated said logical receivers $RX_{sp}$ and $RX_c$ may be embodied in a common physical Receiver NIC.

Said system 10 also comprises a Calculation Unit ALU adapted for calculating conductivity parameters based on said received average measured voltage values and average measured current values. A respective Calculation Unit ALU may be any kind of a microprocessor, microcontroller, FPGA, ASIC, or the like.

Said first logical receiver $RX_{sp}$ is further adapted for Receiving further measured average voltage values and average current values associated with said points of supply SP within the electrical distribution network 1 and said second logical Receiver $RX_c$ is further adapted for Receiving further measured average voltage values and average current values associated with said points of consumption $C_1, C_2, C_n$ within the electrical distribution network 1.

Said logical receivers $RX_{sp}$ and $RX_c$ may be embodied in one or more network cards connected to respective meters located at the Supplier(s) SP and Customers $C_1$, $C_2$, $C_n$. As indicated said logical receivers $RX_{sp}$ and $RX_c$ may be embodied in a common physical Receiver NIC.

Said Calculation Unit ALU is further adapted for analyzing said further received average measured voltages and average measured currents using said calculated conductivity parameters to detect any deviation of measured current values from calculated current valuess with respect to a given point of consumption or point of supply.

If the ALU does not provide a memory sufficient for calculating, a conventional memory MEM may be provided which allows for storing of results, calculation intermediates and for retrieving said data, either for calculation and / or for displaying purposes.

In a further embodiment of the invention the Calculation Unit ALU is further adapted to average said received measured average voltage values and average current values over a predetermined period of time.

In still a further embodiment of the invention, the Calculation Unit ALU is further adapted for determining from the analysis of points a location of loss.

In yet another embodiment of the invention the Calculation Unit ALU is further adapted for determining from the analysis of points an amount of loss.

According to another embodiment of the invention the Calculation Unit ALU is further adapted for calculating of conductivity parameters based on an optimization method. The optimization method is selected from the group comprising Quasi Newton, Conjugated Gradient, Simplex Method, Fuzzy Logic, and Evolution Methods.

It is however understood, that any appropriate method may be chosen. The optimization method may be chosen such that further parameters are taken into account such as time necessity and / or accuracy and / or efficiency.

The target of the optimization is to minimize Error, i.e. while calculating the matrix elements, the matrix elements are varied such that the difference between a measured current and a simulated current is minimized and eventually reaches 0, i.e. there is no error but the model is a true equivalent circuit of the electrical distribution network 1.

Still in another embodiment of the invention the Calculation Unit ALU is further adapted for visualizing the result of the analysis.

Such visualization may be performed by an internal WWW-Server which offers graphical data based on the calculations via a Transmitter TX of a network interface card NIC or it may be provided as a video-signal DIS directed to monitor.

By means of the invention it is now possible without knowing the exact network set-up of the distribution network to detect theft merely by receiving measured values and calculating. Thereby, it is not only achieved that the method is inexpensive but also that the method does not need special trained personnel.

The accuracy is highly increased by allowing detecting not only the time of theft but also detecting the location and amount of theft.

While the invention has been illustrated and described in detail in the drawings and foregoing description, such illustration and description are to be considered illustrative or exemplary and not restrictive; the invention is not limited to the disclosed embodiments.

Other variations to be disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an' does not exclude a plurality. The mere fact that certain measures are recited in mutually different dependent claims does not indicate that a combination of these measures cannot be used to advantage. Any reference signs in the claims should not be construed as limiting scope.

The present invention may be embodied in other specific apparatus and/or methods. The described embodiments are to be considered in all respects as only illustrative and not restrictive.

It should be appreciated by those skilled in the art that any block diagrams herein represent conceptual views of illustrative circuitry embodying the principles of the invention.

In particular, the scope of the invention is indicated by the appended claims rather than by the description and figures herein. All changes that come within the meaning and range of equivalency of the claims are to be embraced within their scope.

## Claims

1. Method for detecting loss in an electrical distribution network, comprising receiving average measured voltage values and average measured current values associated with one or more points of supply within the electrical distribution network;

   receiving average measured voltage values and average measured current values associated with a plurality of points of consumption within the electrical distribution network;

based on said received average measured voltage values and average measured current values calculating conductivity parameters;

receiving further average measured voltage values and average measured current values associated with said points of supply within the electrical distribution network;

receiving further average measured voltage values and average measured current values from said points of consumption within the electrical distribution network; and

analyzing said further received average measured voltage values and average measured current values using said calculated conductivity parameters to detect any deviations of measured current values from calculated current values with respect to a given point of consumption or point of supply.

2. Method according to claim 1, wherein the received average measured voltage values and average measured current values are averaged over a predetermined period of time.

3. Method according to claim 1 or 2, further comprising determining from the analysis of points a location of loss.

4. Method according to any of the preceding claims, further comprising determining from the analysis of points an amount of loss.

5. Method according to any of the preceding claims, wherein the calculation of conductivity parameters is based on an optimization method.

6. Method according to claim 5, wherein the optimization method is selected from the group comprising Quasi Newton, Conjugated Gradient, Simplex Method, Fuzzy Logic, Evolution Methods.

7. Method according to any of the preceding claims, further comprising visualizing the result of the analysis.

8. System adapted for detecting loss in an electrical distribution network, comprising:

a first logical receiver adapted for receiving average measured voltage values and average current values associated with one or more points of supplywithin the electrical distribution network,

a second logical receiver for receiving average measured voltage values and

average measured current values associated with a plurality of points of consumption within the electrical distribution network,

a Calculation Unit adapted for calculating conductivity parameters based on said received average measured voltage values and average measured current values,

wherein said first logical Receiver is further adapted for receiving further average measured voltage values and average measured current values associated with said points of supply within the electrical distribution network wherein said second logical Receiver is further adapted for receiving further average measured voltage values and average measured current values associated with said points of consumption within the electrical distribution network wherein said Calculation Unit is further adapted for analyzing said further received average measured voltages and average measured currents using said calculated conductivity parameters to detect any deviation of measured current values from calculated current values with respect to a given point of consumption or point of supply.

9. System according to claim 8, wherein the Calculation Unit is further adapted to average said received average measured voltage values and average measured current values over a predetermined period of time.

10. System according to claim 8 or 9, wherein said Calculation Unit is further adapted for determining from the analysis of points a location of loss.

11. System according to any of the preceding claims 8 to 10, wherein said Calculation Unit is further adapted for determining from the analysis of points an amount of loss.

12. System according to any of the preceding claims 8 to 11, wherein said Calculation Unit is further adapted for calculating of conductivity parameters based on an optimization method.

13. System according to claim 12, wherein the optimization method is selected from the group comprising Quasi Newton, Conjugated Gradient, Simplex Method, Fuzzy Logic, Evolution Methods.

**14.** System according to any of the preceding claims 8 to 13, wherein said Calculation Unit is further adapted for visualizing the result of the analysis.

Fig .1

EP 2 439 496 A1

Fig. 2

Fig. 3

| Time | Voltage / Potential | | | | Current | 1,00% | | | | |
|---|---|---|---|---|---|---|---|---|---|---|
| T1 | delta U1 | delta U2 | delta U3 | delta U4 | | Is | I | Err_n (t) | I_fraud | Err (t) |
| | 0 | 16,5 | 18 | 26 | | | | 16,56862065 | | |
| 1 | -0,0001 | -0,6659 | -0,6665 | 0,00036 | | -22,97481 | -22,9303851 | 0,001973355 | 0,04 | |
| 2 | -0,6659 | 1,33523 | -0,6671 | 0,00028 | | 10,03087 | 10,05255144 | 0,000470233 | 0,02 | |
| 3 | -0,6665 | -0,6671 | 2,33726 | -0,9999 | | 5,06734 | 5,015564881 | 0,002680672 | 0,05 | |
| 4 | 0,00036 | 0,00028 | -0,9999 | 1,00003 | | 8,008143 | 8,018657948 | 0,00011057 | 0,01 | 0,005234831 |
| T2 | delta U1 | delta U2 | delta U3 | delta U4 | | | | | | |
| | 0 | 12,5 | 19 | 29 | | | | | | |
| 1 | -0,0001 | -0,6659 | -0,6665 | 0,00036 | | -20,97645 | -21,0006373 | 0,000585008 | 0,02 | |
| 2 | -0,6659 | 1,33523 | -0,6671 | 0,00028 | | 4,023681 | 4,003794445 | 0,000395464 | 0,02 | |
| 3 | -0,6665 | -0,6671 | 2,33726 | -0,9999 | | 7,073425 | 7,049554964 | 0,00056979 | 0,02 | |
| 4 | 0,00036 | 0,00028 | -0,9999 | 1,00003 | | 10,00727 | 10,06997941 | 0,003932341 | 0,06 | 0,005482603 |
| T3 | delta U1 | delta U2 | delta U3 | delta U4 | | | | | | |
| | 0 | 3 | 4,5 | 6,5 | | | | | | |
| 1 | -0,0001 | -0,6659 | -0,6665 | 0,00036 | | -4,994525 | -4,99389059 | 4,01844E-07 | 0,00 | |
| 2 | -0,6659 | 1,33523 | -0,6671 | 0,00028 | | 1,00558 | 0,996330061 | 8,55676E-05 | 0,01 | |
| 3 | -0,6665 | -0,6671 | 2,33726 | -0,9999 | | 2,017319 | 5,9831162 | 15,72754431 | 3,97 | |
| 4 | 0,00036 | 0,00028 | -0,9999 | 1,00003 | | 2,001721 | 1,996864266 | 2,35831E-05 | 0,00 | 15,72765386 |
| T4 | delta U1 | delta U2 | delta U3 | delta U4 | | | | | | |
| | 0 | 2 | 2,5 | 3,5 | | | | | | |
| 1 | -0,0001 | -0,6659 | -0,6665 | 0,00036 | | -2,996754 | -3,01169165 | 0,000223139 | 0,01 | |
| 2 | -0,6659 | 1,33523 | -0,6671 | 0,00028 | | 1,003702 | 1,000933883 | 7,66269E-06 | 0,00 | |
| 3 | -0,6665 | -0,6671 | 2,33726 | -0,9999 | | 1,009462 | 0,991614873 | 0,000318525 | 0,02 | |
| 4 | 0,00036 | 0,00028 | -0,9999 | 1,00003 | | 1,001045 | 0,992367382 | 7,53082E-05 | 0,01 | 0,000624635 |
| T5 | delta U1 | delta U2 | delta U3 | delta U4 | | | | | | |
| | 0 | 100,5 | 141 | 207 | | | | | | |
| 1 | -0,0001 | -0,6659 | -0,6665 | 0,00036 | | -160,8225 | -160,461564 | 0,130272344 | 0,36 | |
| 2 | -0,6659 | 1,33523 | -0,6671 | 0,00028 | | 40,18813 | 40,04202607 | 0,021345629 | 0,15 | |
| 3 | -0,6665 | -0,6671 | 2,33726 | -0,9999 | | 55,54036 | 55,37477712 | 0,027418522 | 0,17 | |
| 4 | 0,00036 | 0,00028 | -0,9999 | 1,00003 | | 66,05584 | 66,02662999 | 0,000853493 | 0,03 | 0,179889988 |
| T6 | delta U1 | delta U2 | delta U3 | delta U4 | | | | | | |
| | 0 | 17 | 32,5 | 42,5 | | | | | | |
| 1 | -0,0001 | -0,6659 | -0,6665 | 0,00036 | | -32,96545 | -33,7457328 | 0,608847126 | 0,78 | |
| 2 | -0,6659 | 1,33523 | -0,6671 | 0,00028 | | 1,030196 | 1,004974519 | 0,000636102 | 0,03 | |
| 3 | -0,6665 | -0,6671 | 2,33726 | -0,9999 | | 22,12644 | 22,13568487 | 8,538E-05 | 0,01 | |
| 4 | 0,00036 | 0,00028 | -0,9999 | 1,00003 | | 10,01097 | 9,972957046 | 0,001444687 | 0,04 | 0,611013295 |
| T7 | delta U1 | delta U2 | delta U3 | delta U4 | | | | | | |
| | 0 | 19,5 | 37,5 | 40,5 | | | | | | |
| 1 | -0,0001 | -0,6659 | -0,6665 | 0,00036 | | -37,96325 | -38,1141622 | 0,022774895 | 0,15 | |
| 2 | -0,6659 | 1,33523 | -0,6671 | 0,00028 | | 1,03223 | 1,006009173 | 0,000687525 | 0,03 | |
| 3 | -0,6665 | -0,6671 | 2,33726 | -0,9999 | | 34,1447 | 34,02313622 | 0,0147779 | 0,12 | |
| 4 | 0,00036 | 0,00028 | -0,9999 | 1,00003 | | 3,012328 | 2,990393717 | 0,000481113 | 0,02 | 0,038721433 |

Fig .4

Fig. 5

Fig. 6

Fig. 7

| | Europäisches Patentamt European Patent Office Office européen des brevets | **EUROPEAN SEARCH REPORT** | Application Number EP 10 29 0534 |

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2005/251339 A1 (ARAKI M S [US] ET AL) 10 November 2005 (2005-11-10) | 1-14 | INV. G01D4/00 |
| Y | * the whole document * ----- | 1-14 | G01R31/02 H02J4/00 |
| X | WO 2009/063481 A2 (MAHARASHTRA STATE ELECTRICITY [IN]; MANE UTTAM SHIVRAM [IN]; BAGUL KIS) 22 May 2009 (2009-05-22) | 1-14 | G06Q50/00 |
| Y | * the whole document * ----- | 1-14 | |

TECHNICAL FIELDS SEARCHED (IPC)

G01D
G01R
H02J
G06Q

The present search report has been drawn up for all claims

| Place of search | Date of completion of the search | Examiner |
|---|---|---|
| Munich | 19 April 2011 | Kallinger, Christian |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.** EP 10 29 0534

This annex lists the patent family members relating to the patent documents cited in the above-mentioned European search report.
The members are as contained in the European Patent Office EDP file on
The European Patent Office is in no way liable for these particulars which are merely given for the purpose of information.

19-04-2011

| Patent document cited in search report | Publication date | Patent family member(s) | Publication date |
|---|---|---|---|
| US 2005251339 A1 | 10-11-2005 | WO 2005114416 A2 | 01-12-2005 |
| WO 2009063481 A2 | 22-05-2009 | NONE | |

EPO FORM P0459

For more details about this annex : see Official Journal of the European Patent Office, No. 12/82